(19) Europäisches Patentamt / European Patent Office / Office européen des brevets

(11) **EP 2 764 530 B1**

(12) **FASCICULE DE BREVET EUROPEEN**

(45) Date de publication et mention
de la délivrance du brevet:
**20.11.2019 Bulletin 2019/47**

(21) Numéro de dépôt: **12794357.9**

(22) Date de dépôt: **03.10.2012**

(51) Int Cl.:
*H01J 37/32* (2006.01)       *C23C 14/48* (2006.01)
*G01R 19/00* (2006.01)

(86) Numéro de dépôt international:
**PCT/FR2012/000391**

(87) Numéro de publication internationale:
**WO 2013/050670 (11.04.2013 Gazette 2013/15)**

(54) **MODULE DE COMMANDE POUR IMPLANTEUR IONIQUE EN MODE IMMERSION PLASMA**

STEUERMODUL FÜR PLASMAIMMERSIONS-IONENIMPLANTER

CONTROL MODULE FOR PLASMA IMMERSION ION IMPLANTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.10.2011 FR 1103003**

(43) Date de publication de la demande:
**13.08.2014 Bulletin 2014/33**

(73) Titulaire: **Ion Beam Services**
**13790 Peynier (FR)**

(72) Inventeurs:
• **TORREGROSA, Frank**
  **F-13109 Simiane (FR)**
• **ROUX, Laurent**
  **F-13013 Marseille (FR)**

(74) Mandataire: **Cabinet Prugneau-Schaub**
**Europole - Le Grenat**
**3, avenue Doyen Louis Weil**
**38000 Grenoble (FR)**

(56) Documents cités:
**WO-A1-01/15200          WO-A2-02/25694**
**FR-A1- 2 871 934         US-A1- 2008 075 834**
**US-A1- 2010 155 600      US-B1- 6 433 553**
**US-B1- 6 632 482**

• TIAN XIUBO ET AL: "Accurate determination of pulsed current waveform in plasma immersion ion implantation processes", JOURNAL OF APPLIED PHYSICS, AMERICAN INSTITUTE OF PHYSICS. NEW YORK, US, vol. 86, no. 7, 1 octobre 1999 (1999-10-01), pages 3567-3570, XP012048686, ISSN: 0021-8979, DOI: 10.1063/1.371259

**Description**

La présente invention concerne un module de commande pour implanteur ionique.

Le domaine de l'invention est celui des implanteurs ioniques opérant en mode immersion plasma. Ainsi, l'implantation ionique d'un substrat consiste à l'immerger dans un plasma et à le polariser en tension négative, de quelques dizaines de Volts à quelques dizaines de kilovolts (généralement moins de 100 kV), ceci de façon à créer un champ électrique capable d'accélérer les ions du plasma vers le substrat de sorte qu'ils s'y implantent. Les atomes ainsi implantés sont dénommés dopants.

La profondeur de pénétration des ions est déterminée par leur énergie d'accélération. Elle dépend d'une part de la tension appliquée au substrat et d'autre part de la nature respective des ions et du substrat. La concentration d'atomes implantés dépend de la dose qui s'exprime en nombre d'ions par cm$^2$ et de la profondeur d'implantation.

Un des paramètres essentiels lors de l'implantation est la dose des dopants implantés. Cette dose doit être connue avec précision. Elle est généralement estimée au moyen du courant d'alimentation délivré par le générateur de polarisation.

On considère maintenant le cas où la polarisation du substrat est puisée.

En référence à la figure 1, les documents WO -A1- 01/15200 et WO-A2-02/25694 proposent de polariser le substrat au moyen d'une alimentation qui comporte :

- un générateur GEN dont le pôle positif est raccordé à la masse,
- un premier interrupteur IT1 dont le premier pôle est raccordé au pôle négatif du générateur GEN et dont le second pôle est raccordé à la borne de sortie O de cette alimentation, et
- un deuxième interrupteur IT2 dont le premier pôle est raccordé à la borne de sortie O et dont le second pôle est raccordé à la masse.

Lorsque le premier interrupteur IT1 est ouvert et le second interrupteur IT2 est fermé, un courant de déplacement est produit qui est dû à la capacité équivalente de l'implanteur.

Cette capacité équivalente est la somme de toutes les capacités parasites de la machine :

- capacité des câbles,
- capacité entre les pièces polarisées et les pièces à la masse, notamment la capacité entre le plateau porte-substrat et la chambre d'implantation,
- capacité des transformateurs d'isolation, et
- capacité de la gaine plasma.

Il apparaît que le courant de déplacement est un courant qui ne sert pas à l'implantation mais qui dérive pourtant du courant d'alimentation.

Lorsque l'on estime la dose implantée, il convient donc de prendre en compte ce courant de déplacement pour le soustraire du courant d'alimentation.

Ainsi, le document US-B1-6,433,553 propose d'agencer une capacité de mesure Cm en parallèle avec le porte-substrat.

Cette capacité de mesure Cm devrait être égale à la capacité équivalente de l'implanteur mais cette dernière est pratiquement impossible à déterminer.

De plus, le courant de déplacement Id vaut la dérivée temporelle de la charge Q :

$$Id = dQ / dt$$

La charge Q est le produit de la tension V par la capacité de mesure :

$$Q = Cm \cdot V$$

Il vient que :

$$Id = Cm \cdot dV / dt + V \cdot dCm / dt$$

Le document sus-mentionné prend en compte uniquement le premier terme de l'équation ci-dessus. Il considère que la capacité équivalente est constante, ce qui n'est pas le cas notamment du fait des variations de la gaine plasma. Tian et al montrent dans "Accurate determination of pulsed current waveform in plasma immersion ion implantation process", J.Applied Physics, Vol. 86, Number 7, qu'une bobine de Rogowski peut être utilisée pour mesurer le courant de déplacement qui s'écoule entre la cathode et l'anode.

La présente invention a ainsi pour objet de déterminer le courant de déplacement de manière plus précise.

Selon l'invention, un module de commande pour implanteur ionique, tel que défini dans la revendication 1, comporte une alimentation et cette alimentation comprend :

- un générateur électrique dont le pôle positif est raccordé à la masse,
- un premier interrupteur dont le premier pôle est raccordé au pôle négatif de ce générateur et dont le second pôle est raccordé à la borne de sortie de cette alimentation,
- un deuxième interrupteur dont le premier pôle est raccordé à la borne de sortie et dont le second pôle est relié à une borne de neutralisation ;

de plus, ce module de commande comprend un circuit de mesure du courant configuré de sorte à mesurer, en cours d'utilisation, le courant de déplacement qui s'écoule entre le second pôle du second interrupteur et la borne de neutralisation.

En effet le courant de déplacement s'écoule entre le plateau porte-substrat et la borne de neutralisation.

Suivant une première option, la borne de neutralisation est raccordée à la masse.

Suivant une deuxième option, la borne de neutralisation est raccordée au pôle positif d'une source de tension dont le pôle négatif est raccordé à la masse.

Suivant un premier mode de réalisation, le circuit de mesure de courant est une bobine entourant le câble qui relie le second pôle du second interrupteur à la borne de neutralisation.

Suivant un deuxième mode de réalisation, le circuit de mesure de courant comprend une résistance de mesure connectée entre le second pôle du second interrupteur et le pôle de neutralisation, un condensateur d'intégration en parallèle sur cette résistance de mesure et un circuit de mesure de tension également en parallèle sur cette résistance de mesure.

Avantageusement, le module de commande comporte de plus un condensateur de régulation agencé entre le pôle négatif du générateur et la masse.

Ainsi, le module de commande comportant un module d'estimation du courant d'alimentation délivré, en cours d'utilisation, par le générateur, il comporte encore un circuit de contrôle configuré pour estimer le courant d'implantation par différentiation du courant d'alimentation et du courant de déplacement.

Par ailleurs, le courant d'implantation étant donc la différence entre le courant d'alimentation et le courant de déplacement, ce courant d'implantation ne représente pas uniquement le courant des ions implantés.

En effet, les charges positives ne sont pas dues seulement aux ions positifs atteignant le substrat, mais elles proviennent aussi de la génération d'électrons secondaires libérés à la surface du substrat.

Sur les implanteurs par faisceau d'ions, les électrons secondaires sont peu énergétiques, si bien qu'on peut les ramener vers le substrat au moyen d'une cage de Faraday qui entoure ce dernier, cette cage étant fermée optiquement par une barrière de potentiel négatif.

Sur un implanteur fonctionnant en mode immersion plasma, les électrons secondaires sont accélérés avec une énergie sensiblement identique à celle des ions positifs du plasma, si bien qu'il est beaucoup plus difficile de les ramener vers le substrat.

La présente invention a ainsi également pour objet de prendre en compte la contribution des électrons secondaires au courant d'implantation.

Selon l'invention, le module de commande comportant un module d'estimation du courant d'alimentation délivré, en cours d'utilisation, par le générateur, étant susceptible de recevoir, en cours d'utilisation, un courant de perturbation issu d'un détecteur d'électrons secondaires, il comporte encore un circuit de contrôle configuré pour estimer le courant ionique en soustrayant du courant d'alimentation le courant de déplacement et le courant de perturbation.

De plus, lorsque le circuit de contrôle reçoit, en cours d'utilisation, d'un spectromètre la proportion d'une espèce ionique prédéterminée, ce circuit de contrôle est configuré de sorte à affecter cette proportion au courant ionique pour estimer la dose implantée.

L'invention vise encore un implanteur ionique, tel que défini dans la revendication 10, pourvu d'un module de commande muni d'un plateau porte-substrat, la borne de sortie de cette alimentation étant raccordée au plateau porte-substrat.

La présente invention apparaîtra maintenant avec plus de détails dans le cadre de la description qui suit d'un exemple de réalisation donné à titre illustratif en se référant aux figures jointes parmi lesquelles :

- la figure 1 représente une alimentation haute tension selon l'état de l'art,
- la figure 2 représente un implanteur ionique pourvu d'un module de commande,
- la figure 3 représente une alimentation électrique haute tension selon l'invention, et
- la figure 4 représente un mode de réalisation du circuit de mesure de courant.

Les éléments présents sur plusieurs figures sont affectés d'une seule et même référence.

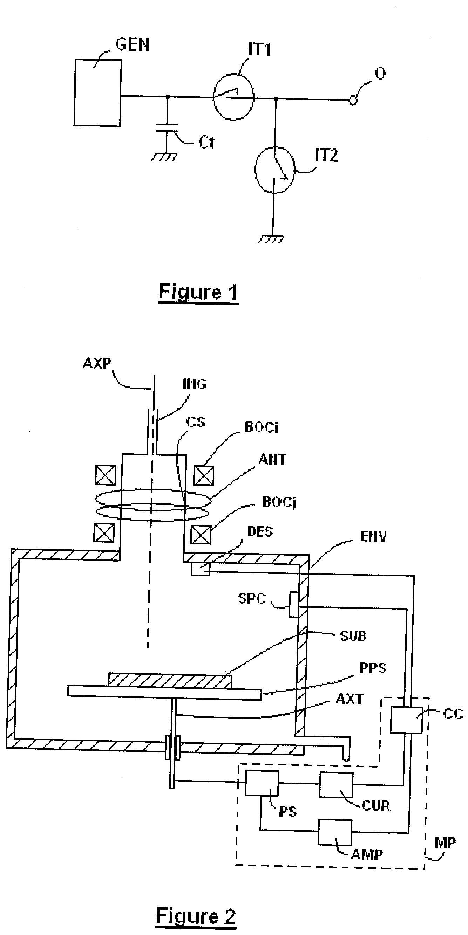

En référence à la figure 2, un implanteur ionique comporte plusieurs éléments agencés à l'intérieur et à l'extérieur d'une enceinte à vide ENV. Pour les applications microélectroniques, il est préconisé d'utiliser une enceinte en alliage d'aluminium si l'on souhaite limiter la contamination en éléments métalliques tels que Fer, Chrome, Nickel ou Cobalt. Un revêtement en silicium ou en carbure de Silicium peut aussi être utilisé.

Un plateau porte substrat PPS, se présentant sous la forme d'un disque à plan horizontal, mobile autour de son axe vertical AXT, reçoit le substrat SUB devant subir l'implantation ionique.

La partie supérieure de l'enceinte ENV reçoit le corps de source CS, cylindrique, d'axe vertical AXP. Ce corps est en quartz. Il est extérieurement entouré, d'une part par des bobines de confinement BOCi, BOCj, et d'autre part par une antenne radiofréquence ANT extérieure. L'entrée de gaz plasmagène ING est coaxiale à l'axe vertical AXP du corps de source CS. Cet axe vertical AXP rencontre la surface du plateau porte substrat PPS sur lequel est disposé le substrat à implanter SUB.

Il est possible d'utiliser tout type de source plasma pulsée : décharge, ICP (pour « Inductively Coupled Plasma » en anglais), Helicon, micro-ondes, arc. Ces sources doivent travailler à des niveaux de pression suffisamment faibles pour que le champ électrique créé entre le plateau PPS à haute tension et l'enceinte ENV à la masse n'allume pas un plasma de décharge qui vienne perturber le fonctionnement pulsé de la source.

L'implanteur comporte encore un détecteur d'électrons secondaires DES disposé face au substrat SUB. Il comporte aussi un spectromètre SPC, par exemple un spectromètre de masse ou un spectromètre optique, agencé dans l'enceinte ENV. Ce spectromètre identifie la proportion de l'espèce implantée dans le plasma.

Le module de commande MP de l'implanteur comporte essentiellement quatre éléments :

- une alimentation électrique haute tension PS,
- un circuit de mesure du courant de déplacement AMP,
- un organe d'estimation du courant d'alimentation CUR, et
- un circuit de contrôle CC.

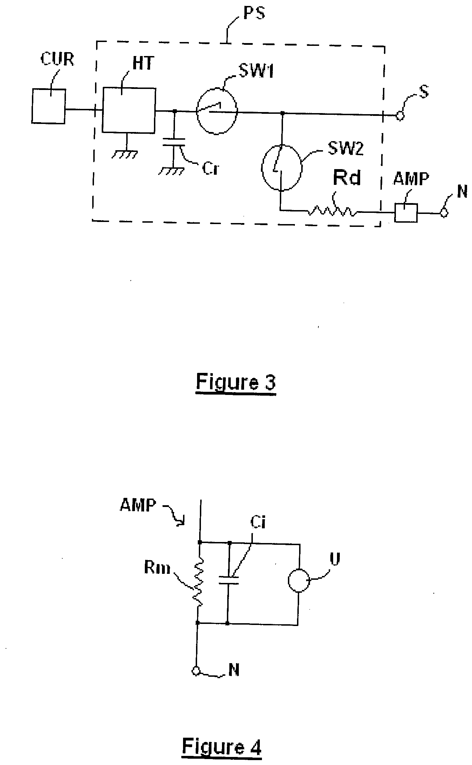

En référence à la figure 3, l'alimentation PS comporte :

- un générateur haute tension HT dont le pôle positif est raccordé à la masse,
- un premier interrupteur SW1 dont le premier pôle est raccordé au pôle négatif du générateur HT et dont le second pôle est raccordé à la borne de sortie S de cette alimentation,
- un deuxième interrupteur SW2 dont le premier pôle est raccordé à la borne de sortie S et dont le second pôle est relié à une borne de neutralisation N soit directement, soit par l'intermédiaire d'une résistance de décharge Rd qui vaut typiquement 1kΩ,
- de préférence, un condensateur de régulation Cr connecté en parallèle sur le générateur HT.

La borne de sortie S est raccordée au plateau porte-substrat PPS de l'implanteur.

Un organe d'estimation du courant d'alimentation CUR, l'équivalent d'un ampèremètre, donne une mesure du courant d'alimentation délivré par le générateur HT au plateau porte-substrat PPS.

La borne de neutralisation peut être raccordée à la masse. Elle peut également être raccordée au pôle positif d'une source de tension dont le pôle négatif est raccordé à la masse. Cette tension positive est choisie sensiblement égale au potentiel plasma qui est généralement compris entre + 10 et + 20 Volts.

Un circuit de mesure de courant AMP mesure le courant de déplacement qui s'écoule entre le second pôle du deuxième interrupteur SW2 et la borne de neutralisation N.

Suivant un premier mode de réalisation, ce circuit de mesure de courant est une bobine entourant le câble qui véhicule ce courant de déplacement. Il s'agit là de la mesure du courant instantané or ce courant varie extrêmement rapidement. Pour éviter de recourir à une électronique de mesure rapide, on préfère mesurer la valeur moyenne de ce courant.

Ainsi, en référence à la figure 4, suivant un second mode de réalisation, le circuit de mesure du courant AMP est un circuit de moyennage. Il comprend une résistance de mesure Rm connectée entre le second pôle du second interrupteur SW2 et le pôle de neutralisation, un condensateur d'intégration Ci en parallèle sur cette résistance de mesure Rm et un circuit de mesure de tension U également en parallèle sur cette résistance de mesure Rm. La tension mesurée reflète la valeur moyenne du courant de déplacement.

La résistance de mesure Rm doit avoir une valeur telle que la tension à ses bornes soit suffisante pour être aisément mesurée avec précision. Sa valeur typique est de l'ordre de 10Ω.

En revenant à la figure 2, le module de commande MP comporte donc le circuit de contrôle CC qui reçoit le courant d'alimentation fourni par l'organe d'estimation du courant CUR et qui reçoit aussi le courant de déplacement fourni par le circuit de mesure AMP. Il fait la différence de ces deux courants pour calculer le courant d'implantation qui reflète beaucoup mieux la dose implantée que le courant d'alimentation.

On affine la mesure de dose de la manière suivante.

Le circuit de contrôle reçoit de plus le courant de perturbation issu du détecteur d'électrons secondaires DES et il calcule maintenant le courant ionique en soustrayant du courant d'alimentation le courant de déplacement et le courant de perturbation.

On améliore encore sensiblement la mesure de dose au moyen du spectromètre SPC. Le circuit de contrôle reçoit de ce dernier la proportion de l'espèce implantée dans le plasma et la multiplie par le courant ionique pour donner une estimation de la dose.

L'exemple de réalisation de l'invention présenté ci-dessus a été choisi eu égard à son caractère concret. Il ne serait cependant pas possible de répertorier de manière exhaustive tous les modes de réalisation que recouvre cette invention. En particulier, tout moyen décrit peut être remplacé par un moyen équivalent sans sortir du cadre de la présente invention. L'invention est définie par les revendications.

**Revendications**

1.  Module de commande pour implanteur ionique comportant une alimentation (PS), cette alimentation (PS) comprenant:

    - un générateur électrique (HT) dont le pôle positif est raccordé à la masse,
    - un premier interrupteur (SW1) dont le premier pôle est raccordé au pôle négatif dudit générateur (HT) et dont le second pôle est raccordé à la borne de sortie (S) de cette alimentation,
    - un deuxième interrupteur (SW2) dont le premier pôle est raccordé à ladite borne de sortie (S) et dont le second pôle est relié à une borne de neutralisation (N),

**caractérisé en ce que** le module de commande comprend un circuit de mesure du courant (AMP) configuré de sorte à mesurer, en cours d'utilisation, le courant de déplacement qui s'écoule entre le second pôle dudit second interrupteur (SW2) et ladite borne de neutralisation (N).

2. Module de commande selon la revendication 1, **caractérisé en ce que** ladite borne de neutralisation (N) est raccordée à la masse.

3. Module de commande selon la revendication 1, **caractérisé en ce que** ladite borne de neutralisation (N) est raccordée au pôle positif d'une source de tension dont le pôle négatif est raccordé à la masse.

4. Module de commande selon l'une quelconque des revendications précédentes, **caractérisé en ce que** ledit circuit de mesure de courant (AMP) est une bobine entourant le câble qui relie le second pôle dudit second interrupteur (SW2) à ladite borne de neutralisation (N).

5. Module de commande selon l'une quelconque des revendications 1 à 3, **caractérisé en ce que** ledit circuit de mesure de courant (AMP) comprend une résistance de mesure (Rm) connectée entre le second pôle du second interrupteur (SW2) et ledit pôle de neutralisation (N), un condensateur d'intégration (Ci) en parallèle sur cette résistance de mesure (Rm) et un circuit de mesure de tension (U) également en parallèle sur cette résistance de mesure (Rm).

6. Module de commande selon l'une quelconque des revendications précédentes, **caractérisé en ce qu'**il comporte de plus un condensateur de régulation (Cr) agencé entre le pôle négatif dudit générateur (HT) et la masse.

7. Module de commande selon l'une quelconque des revendications précédentes **caractérisé en ce que**, comportant un organe d'estimation du courant d'alimentation (CUR) délivré, en cours d'utilisation, par ledit générateur (HT), il comporte encore un circuit de contrôle (CC) configuré pour estimer le courant d'implantation par différentiation dudit courant d'alimentation et dudit courant de déplacement.

8. Module de commande selon l'une quelconque des revendications 1 à 6, **caractérisé en ce que**, comportant un module d'estimation du courant d'alimentation (CUR) délivré, en cours d'utilisation, par ledit générateur (HT), étant susceptible de recevoir, en cours d'utilisation, un courant de perturbation issu d'un détecteur d'électrons secondaires (DES), il comporte encore un circuit de contrôle (CC) configuré pour estimer le courant ionique en soustrayant dudit courant d'alimentation ledit courant de déplacement et ledit courant de perturbation.

9. Module de commande selon la revendication 8 **caractérisé en ce que**, ledit circuit de contrôle (CC) étant susceptible de recevoir de plus, en cours d'utilisation, la proportion d'une espèce ionique prédéterminée d'un spectromètre (SPC), ce circuit de contrôle (CC) est configuré de sorte à affecter ladite proportion audit courant ionique pour estimer la dose implantée.

10. Implanteur ionique pourvu d'un module de commande selon l'une quelconque des revendications précédentes, **caractérisé en ce que**, muni d'un plateau porte-substrat (PPS), la borne de sortie (S) de l'alimentation (PS) est raccordée audit plateau porte-substrat (PPS).

**Patentansprüche**

1. Steuermodul für Ionenimplanter, umfassend eine Versorgung (PS), diese Versorgung (PS) umfassend:

- einen elektrischen Generator (HT), dessen positiver Pol mit der Masse verbunden ist,
- einen ersten Schalter (SW1), dessen erster Pol mit dem negativen Pol des Generators (HT) verbunden ist und dessen zweiter Pol mit dem Ausgangsanschluss (S) dieser Versorgung verbunden ist,
- einen zweiten Schalter (SW2), dessen erster Pol mit dem Ausgangsanschluss (S) verbunden ist und dessen zweiter Pol mit einem Neutralanschluss (N) verbunden ist,

**dadurch gekennzeichnet,**
**dass** das Steuermodul eine Strommessschaltung (AMP) umfasst, die derart konfiguriert ist, dass im Betrieb der Verschiebungsstrom, der zwischen dem zweiten Pol des zweiten Schalters (SW2) und dem Neutralanschluss (N) fließt, gemessen wird.

2. Steuermodul nach Anspruch 1, **dadurch gekennzeichnet, dass** der Neutralanschluss (N) mit der Masse verbunden ist.

3. Steuermodul nach Anspruch 1, **dadurch gekennzeichnet, dass** der Neutralanschluss (N) mit dem positiven Pol einer Spannungsquelle verbunden ist, deren negativer Pol mit der Masse verbunden ist.

4. Steuermodul nach einem der vorhergehenden Ansprüche, **dadurch gekennzeichnet, dass** die Strommessschaltung (AMP) eine die den zweiten Pol des zweiten Schalters (SW2) mit dem Neutralanschluss (N) verbindende Leitung umgebende Spule ist.

5. Steuermodul nach einem der Ansprüche 1 bis 3, **dadurch gekennzeichnet, dass** die Strommessschaltung (AMP) einen zwischen dem zweiten Pol des zweiten Schalters (SW2) und dem Neutralanschluss (N) verbundenen Messwiderstand (Rm), einen zu dem Messwiderstand (Rm) parallelen Integrationskondensator (Ci) und eine auch zu dem Messwiderstand (Rm) parallele Spannungsmessschaltung (U) umfasst.

6. Steuermodul nach einem der vorhergehenden Ansprüche, **dadurch gekennzeichnet, dass** es ferner einen zwischen dem negativen Pol des Generators (HT) und der Masse angeordneten Einstellkondensator (Cr) umfasst.

7. Steuermodul nach einem der vorhergehenden Ansprüche, **dadurch gekennzeichnet, dass** dieses ein Abschätzorgan des im Betrieb von dem Generator (HT) abgelieferten Versorgungsstroms (CUR) und eine Überwachungsschaltung (CC), konfiguriert zum Abschätzen des Implantierstroms durch Differenzierung des Versorgungsstroms und des Verschiebungsstroms, umfasst.

8. Steuermodul nach einem der Ansprüche 1 bis 6, **dadurch gekennzeichnet, dass** dieses ein Abschätzmodul des im Betrieb durch den Generator (HT) abgelieferten Versorgungsstroms (CUR) umfasst und das in der Lage ist, im Betrieb einen von einem Sekundärelektronendetekor (DES) ausgehenden Störstrom zu empfangen und ferner eine Überwachungsschaltung (CC), konfiguriert zum Abschätzen des Ionenstroms durch Subtraktion, von dem Versorgungsstrom, des Verschiebungsstroms und des Störstroms, umfasst.

9. Steuermodul nach Anspruch 8, **dadurch gekennzeichnet, dass** die Überwachungsschaltung (CC) in der Lage ist, zusätzlich im Betrieb einen Anteil einer vorbestimmten Ionensorte eines Spektrometers (SPC) zu erhalten, wobei die Überwachungsschaltung (CC) konfiguriert ist, um den Anteil an dem Ionenstrom zu beeinflussen, um die implantierte Dosis abzuschätzen.

10. Ionenimplanter, ausgestattet mit einem Steuermodul nach einem der vorhergehenden Ansprüche, **dadurch gekennzeichnet, dass** dieser mit einer Substratträgerplatte (PPS) ausgestattet ist und der Ausgangsanschluss (S) der Versorgung (PS) mit der Substratträgerplatte (PPS) verbunden ist.

**Claims**

1. A control module for an ion implanter having a power supply (PS), the power supply (PS) comprising:

   - an electricity generator (HT) having its positive pole connected to the ground,
   - a first switch (SW1) having its first pole connected to the negative pole of said generator (HT) and having its second pole connected to the outlet terminal (S) of this power supply, and
   - a second switch (SW2) having its first pole connected to said outlet terminal (S) and having its second pole connected to a neutralization terminal (N),

   the control module being **characterized in that** said control module comprises a current measurement circuit (AMP) configured so as to measure, in use, the displacement current that flows between the second pole of said second switch (SW2) and said neutralization terminal (N).

2. A control module according to claim 1, **characterized in that** said neutralization terminal (N) is connected to ground.

3. A control module according to claim 1, **characterized in that** said neutralization terminal (N) is connected to the positive pole of a voltage source having its negative pole connected to ground.

4. A control module according to any one of the preceding claims, **characterized in that** said current measurement circuit (AMP) is a coil surrounding the cable connecting the second pole of said second switch (SW2) to said neutralization terminal (N).

5. A control module according to any one of claims 1 to 3, **characterized in that** said current measurement circuit (AMP) comprises a measurement resistor (Rm) connected between the second pole of the second switch (SW2) and said neutralization terminal (N), an integration capacitor (Ci) in parallel with this measurement resistor (Rm) and a voltage measuring circuit (U) likewise in parallel with the measurement resistor (Rm).

6. A control module according to any one of the preceding claims, **characterized in that** it further includes a control capacitor (Cr) arranged between the negative pole of said generator (HT) and ground.

7. A control module according to any one of the preceding claims, **characterized in that** it includes member (CUR) for estimating the power supply current delivered, in use, by said generator (HT) and it further includes a control circuit (CC) configured for estimating the implantation current by differentiating said power supply current and said displacement current.

8. A control module according to any one of claims 1 to 6, **characterized in that** it includes an estimation module (CUR) for estimating a power supply current delivered, in use, by said generator (HT) and that is susceptible of receiving, in use, a disturbance current delivered by a secondary electron detector (DES), and it further includes a control circuit (CC) configured for estimating the ion current by subtracting said displacement current and said disturbance current from said power supply current.

9. A control module according to claim 8, **characterized in that** said control circuit (CC) being susceptible of also receiving, in use, the proportion of a predetermined ionic species as determined by a spectrometer (SPC), and said control circuit (CC) is configured so as to allocate said proportion to said ion current in order to estimate the implanted dose.

10. An ion implanter provided with a control module according to any one of the preceding claims, **characterized in that** it has a substrate carrier platen (PPS) with the outlet terminal (S) of said power supply (PS) connected to said substrate carrier platen (PPS).

GEN  IT1  O  Ct  IT2

## Figure 1

AXP  ING  CS  BOCi  ANT  BOCj  DES  ENV  SPC  SUB  PPS  AXT  CC  PS  CUR  AMP  MP

## Figure 2

**Figure 3**

**Figure 4**

## RÉFÉRENCES CITÉES DANS LA DESCRIPTION

**Documents brevets cités dans la description**

- WO 0115200 A1
- WO 0225694 A2
- US 6433553 B1

**Littérature non-brevet citée dans la description**

- **TIAN et al.** Accurate determination of pulsed current waveform in plasma immersion ion implantation process. *J.Applied Physics,* vol. 86 (7